# FASCICULE DE BREVET EUROPEEN

(11) **EP 3 501 907 B1**
(45) Date de publication et mention de la délivrance du brevet: **14.10.2020**
(21) Numéro de dépôt: 18210460.4
(22) Date de dépôt: 05.12.2018
(51) Int. Cl.: B60R 16/023, H05K 5/00

(54) **ÉLÉMENT DE BOITIER D'UN ÉQUIPEMENT ÉLECTRIQUE, EN PARTICULIER COMPRENANT DES PIÈCES MAGNÉTIQUES EN U**
GEHÄUSEELEMENT EINER ELEKTRISCHEN AUSSTATTUNG, DAS INSBESONDERE U-FÖRMIGE MAGNETTEILE UMFASST
HOUSING ELEMENT OF ELECTRICAL EQUIPMENT, IN PARTICULAR COMPRISING U-SHAPED MAGNETIC PARTS

(30) Priorité: 22.12.2017 FR 1762967
(43) Date de publication de la demande: 26.06.2019
(73) Titulaire: Valeo Siemens eAutomotive France SAS, 95800 Cergy (FR)
(72) Inventeur: TRAMET, Guillaume, 78920 Ecquevilly (FR); MAS, Arnaud, 92000 Nanterre (FR)
(74) Mandataire: Argyma

(56) Documents cités:
- EP-A1- 2 584 690
- EP-A2- 2 916 634
- WO-A1-2017/081255
- US-A- 5 583 429

## Description

### DOMAINE TECHNIQUE ET OBJET DE L'INVENTION

La présente invention concerne un élément de boîtier pour un équipement électrique, notamment de véhicule électrique est hybride.

L'invention se rapporte au domaine des équipements électriques haute tension pour véhicules électriques et hybrides.

L'invention vise notamment à permettre un assemblage adapté à la grande série de pièces magnétiques en forme de 'U' sur un élément de boîtier d'un équipement électrique pour véhicule.

### ETAT DE LA TECHNIQUE

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

La batterie d'alimentation haute tension assure une fonction d'alimentation en énergie du système de motorisation électrique permettant la propulsion du véhicule. Plus précisément, afin de commander la machine électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Dans une solution connue, l'onduleur se présente sous la forme d'un boîtier dans lequel sont montés un module électronique de puissance et une unité électronique de contrôle. L'onduleur comprend un corps comportant des composants électriques par lesquels passe l'énergie alimentant le moteur électrique. L'unité électronique de contrôle comprend des composants électroniques permettant de contrôler le module électronique de puissance.

Afin de connecter le module électronique de puissance à la batterie haute tension, le module électronique de puissance comprend un conducteur électrique dit « de potentiel positif » relié au potentiel positif de la batterie d'alimentation haute tension et un conducteur électrique dit « de potentiel négatif » relié au potentiel négatif de la batterie d'alimentation haute tension. Afin de connecter ces conducteurs électriques il est connu dans l'état de la technique d'utiliser un élément de boîtier comme dans EP 2 916 634.

En outre, dans le cas d'un moteur triphasé, l'onduleur comprend trois conducteurs électriques, dits « conducteurs de phase », permettant de relier le module électronique de puissance au moteur électrique afin de le commander en utilisant trois courants dits « de phase » déphasés deux à deux, par exemple de 120°, générés par l'onduleur à partir du courant continu délivré par la batterie haute tension.

Pour commander de façon adaptée le courant transféré à une machine électrique via de tels conducteurs de phase, il est nécessaire de mesurer l'intensité des courants qui y circulent, au moyen de capteurs adaptés, notamment de capteurs à effet Hall.

Pour permettre aux capteurs à effet Hall de réaliser des mesures de l'intensité des courants circulant dans les conducteurs de phase, il est connu de prévoir des organes assurant une fonction de focalisation du champ magnétique produit par lesdits courants. Ce champ magnétique est destiné à être capté par le capteur à effet Hall correspondant, monté sur l'unité de contrôle électronique. A partir de ce champ magnétique, ledit capteur mesure l'intensité du courant circulant dans le conducteur.

Selon l'état de la technique, lesdits organes focalisateurs du champ magnétique sont surmoulés sur les conducteurs de phase. Un premier inconvénient réside dans le coût induit par de telles opérations de surmoulage dans le contexte d'une production en grande série. Un deuxième inconvénient réside dans le fait que le surmoulage engendre un choc thermique affectant l'organe destiné à focaliser le champ magnétique. Ce choc thermique entraîne une dégradation des performances desdits organes focalisateurs du champ magnétique en provoquant une désorganisation de l'orientation des molécules constitutives de la matière desdits organes.

Dans l'état de l'art, la solution consiste à modifier les réglages des capteurs de courant pour modifier de façon empirique les valeurs mesurées.

Il existe donc un besoin pour un positionnement d'un organe focalisateur du champ magnétique, apte à assurer une fonction de focalisation des champs magnétiques suscités par au moins un conducteur électrique d'un équipement électrique, notamment en vue de permettre la réalisation de mesures directes et fiables de l'intensité du courant circulant dans ledit conducteur électrique.

A cette fin, la présente invention vise un élément de boîtier comprenant une zone de réception d'au moins un conducteur électrique et au moins une paire de fentes destinées à se trouver de part et d'autre dudit conducteur électrique de façon à ce qu'y soient engagées les branches planes d'une pièce ayant une section en 'U', lesdites branches étant configurées pour assurer une fonction de focalisation du champ magnétique généré par le courant circulant dans ledit conducteur électrique.

### PRESENTATION GENERALE DE L'INVENTION

A cet effet, l'invention a tout d'abord pour objet un élément de boîtier d'un premier équipement électrique, notamment d'un véhicule électrique ou hybride, ledit élément de boîtier étant configuré pour recevoir au moins un conducteur électrique destiné à recevoir un courant électrique.

Ledit élément de boîtier est remarquable en ce qu'il comprend une paire de fentes aménagées dans une paroi de l'élément de boîtier, la paire de fentes comprenant une fente de part et d'autre d'une zone de réception destinée à recevoir ledit conducteur électrique et ladite paire de fentes étant destinée à permettre l'engagement d'une pièce ayant une section en forme de 'U' présentant une base et deux branches parallèles entre elles et orthogonales à la base, lesdites branches étant configurées pour être engagées dans lesdites fentes de part et d'autre de ladite zone de réception, de sorte que la pièce en forme de 'U' assure un guidage d'un flux magnétique généré par un courant électrique circulant dans ledit conducteur électrique.

L'élément de boîtier permet ainsi l'insertion de pièces magnétiques en 'U' dans les paires de fentes pour assurer une fonction de focalisation des champs électromagnétiques induits par les courants circulant dans le conducteur électrique reçu dans la zone de réception, afin de permettre une mesure fiable de l'intensité desdits courants par des capteurs, par exemple des capteurs à effet Hall connectés sur une carte électronique fixée dans l'élément de boîtier.

Le conducteur électrique peut être une lame réalisée en matériau conducteur électrique, par exemple en cuivre, acier ou aluminium. La lame est de préférence pliée. Le conducteur électrique comprend notamment une première extrémité adaptée pour être connectée électriquement à un composant du premier équipement électrique, par exemple un module électronique de puissance, et une deuxième extrémité adaptée pour être connectée électriquement à un deuxième équipement électrique, par exemple une machine électrique.

Selon une forme de réalisation, une ouverture en 'U' est aménagée dans la paroi entre les fentes de la paire de fentes de façon à former une languette, ladite languette présentant une protubérance et une souplesse adaptée pour assurer une fonction de clip de fixation pour retenir la base de la pièce en forme de 'U' engagée dans la paire de fentes.

Selon une forme de réalisation, ledit élément de boîtier étant monobloc.

La présente invention vise également un équipement électrique comprenant un élément de boîtier tel que brièvement décrit ci-dessus, comprenant au moins une pièce en matériau magnétique en forme de 'U', présentant une base et deux branches parallèles entre elles et orthogonales à la base, lesdites branches étant engagées dans lesdites fentes de part et d'autre de la zone de réception, ladite pièce en forme de 'U' étant configurée pour assurer un guidage d'un flux magnétique généré par un courant circulant dans un conducteur électrique reçu dans la zone de réception.

Selon une forme de réalisation, l'équipement électrique comprend un conducteur électrique monté dans la zone de réception, et dans lequel le conducteur électrique verrouille la pièce en forme de 'U'.

De préférence, la souplesse de la languette est configurée pour permettre un désengagement de la pièce en forme de 'U' par une pression sur ladite languette dans une direction opposée à la base de la pièce en forme de 'U'.

Selon un mode de réalisation, le conducteur électrique verrouille la pièce en forme de 'U' en inhibant un déplacement de la languette dans une direction opposée à la base de la pièce en forme de 'U' susceptible de permettre un désengagement de ladite pièce en forme de 'U'.

Selon une forme de réalisation, une portion du conducteur électrique assure la fonction de verrouillage de la pièce en forme de 'U', ladite portion correspondant à une surface dudit conducteur électrique parallèle à la paroi et venant en appui contre la languette, inhibant tout degré de liberté de la languette dans une direction orthogonale à ladite paroi et opposée à la base de ladite pièce en forme de 'U'.

Selon un mode de réalisation, la paroi forme une paroi externe de l'équipement électrique et le conducteur électrique comprend une extrémité formant une borne électrique externe de l'équipement électrique et une autre connectée à un composant électrique inclus dans ledit élément de boîtier, ladite pièce en forme de 'U' étant configurée pour guider un champ magnétique produit par un courant circulant dans ledit conducteur électrique pour une mesure dudit courant.

Avantageusement, l'équipement électrique comprend un capteur, notamment un capteur à effet Hall, situé entre les branches de la pièce en forme de 'U' de manière à mesurer un courant circulant dans le conducteur électrique à partir d'un champ magnétique guidé par la pièce en forme de 'U'.

Avantageusement, l'équipement électrique comprend une carte électronique montée dans ledit élément de boîtier, ledit capteur étant monté sur la carte électronique, et ladite carte électronique présentant des fentes dans lesquelles les branches de la pièce en forme de 'U' sont engagées.

Selon une forme de réalisation, la carte électronique est perpendiculaire à la paroi, et les branches de la pièce en forme de 'U' s'introduisent dans lesdites fentes suivant une direction parallèle au plan de ladite carte électronique.

Selon un aspect de l'invention, le conducteur électrique est fixé sur une borne d'un composant du premier équipement électrique, par exemple un module électronique de puissance.

Dans une forme de réalisation, l'équipement électrique est un onduleur destiné à être électriquement connecté, d'une part, à une machine électrique du véhicule et, d'autre part, à une batterie d'alimentation haute tension du véhicule.

Selon un aspect de l'invention, l'onduleur comprend un module électronique de puissance apte à convertir un courant continu en une pluralité de courants alternatifs dits « courants de phase », ladite pluralité de courants de phase circulant entre le module électronique de puissance et la machine électrique du véhicule via la pluralité de conducteurs électriques.

Par les termes « module électronique de puissance apte à convertir un courant continu en une pluralité de courants alternatifs », on entend que le module électronique de puissance peut être configuré pour convertir un courant continu en une pluralité de courants alternatifs et/ou pour convertir une pluralité de courants alternatifs en un courant continu.

L'invention concerne aussi un véhicule électrique ou hybride comprenant une machine électrique, par exemple une machine de motorisation, alimentée par une batterie d'alimentation haute tension via un réseau électrique embarqué haute tension et un équipement électrique, tel que présenté précédemment, connecté à ladite machine électrique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 est une vue en perspective d'une forme de réalisation d'un onduleur selon l'invention,
- la figure 2 est une vue partielle en perspective de l'ensemble formé du module électronique, de l'unité électronique de contrôle, du premier conducteur électrique de potentiel positif, du premier conducteur électrique de potentiel négatif et de la barre de fixation de l'onduleur de la figure 1,
- la figure 3 est une vue en perspective d'un ensemble de conducteurs électriques,
- la figure 4 est une vue en perspective de l'élément de boîtier de l'onduleur de la figure 1, comprenant des pièces en forme de 'U',
- la figure 5 est une vue en perspective partielle rapprochée de l'élément de boîtier de la figure 4 montrant les deux branches d'une pièce en forme de 'U' et la languette assurant la retenue de ladite pièce en forme de 'U',
- la figure 6 est une vue en perspective d'une pièce en forme de 'U' prise isolément,
- la figure 7 est une vue en perspective de l'élément de boîtier de la figure 4 sur lequel sont montés les conducteurs électriques de la figure 3 et les pièces en 'U' de la figure 6,
- la figure 8 est une vue du dessous de l'élément de boîtier selon l'invention, dans lequel est disposée une carte électronique.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention.

Dans l'exemple décrit ci-après, le véhicule comprend notamment une machine électrique, un équipement électrique se présentant sous la forme d'un onduleur, une batterie d'alimentation haute tension, un réseau électrique embarqué haute tension, une batterie d'alimentation basse tension, un réseau électrique embarqué basse tension et une pluralité d'équipements électriques auxiliaires.

L'équipement électrique selon l'invention est décrit ci-après dans sa mise en œuvre pour un onduleur, sans toutefois que cela ne limite la portée de la présente invention. On notera ainsi que l'équipement électrique pourrait être autre chose qu'un onduleur, par exemple un chargeur ou un convertisseur DCDC embarqués dans le véhicule.

Le réseau électrique embarqué basse tension relie la batterie d'alimentation basse tension et la pluralité d'équipements électriques auxiliaires afin que la batterie d'alimentation basse tension alimente lesdits équipements électriques auxiliaires, tels que des calculateurs embarqués, des moteurs de lève-vitres, un système multimédia, etc. La batterie d'alimentation basse tension délivre typiquement par exemple une tension de l'ordre de 12 V, 24 V ou 48 V. La recharge de la batterie basse tension est réalisée à partir de la batterie haute tension via un convertisseur de tension continue en tension continue, appelé communément convertisseur continu-continu.

Le réseau électrique embarqué haute tension relie la batterie d'alimentation haute tension et l'onduleur afin que la batterie d'alimentation haute tension assure une fonction d'alimentation en énergie de la machine électrique via l'onduleur. La batterie d'alimentation haute tension délivre typiquement une tension comprise entre 100 V et 900 V, de préférence entre 100 V et 500 V. La recharge en énergie électrique de la batterie d'alimentation haute tension est réalisée en la connectant, via le réseau électrique haute tension continue du véhicule, à un réseau électrique externe, par exemple le réseau électrique alternatif domestique.

La machine électrique est une machine électrique tournante, de préférence destinée à entrainer les roues du véhicule à partir de l'énergie fournie par la batterie d'alimentation haute-tension. Plus précisément, la machine électrique est une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention.

Dans cet exemple, la commande de la machine électrique est réalisée au moyen de l'onduleur. Ledit onduleur permet de convertir le courant continu fourni par la batterie d'alimentation haute tension en trois courants de commande alternatifs, par exemple sinusoïdaux. Autrement dit, l'onduleur a pour fonction de transformer le courant continu délivré en entrée par la batterie d'alimentation haute tension en trois courants de phase permettant de commander la machine électrique. A l'inverse, dans un autre mode de fonctionnement, la machine électrique peut également fournir trois courants alternatifs à l'onduleur afin que ledit onduleur les transforme en un courant continu permettant de charger la batterie d'alimentation haute-tension.

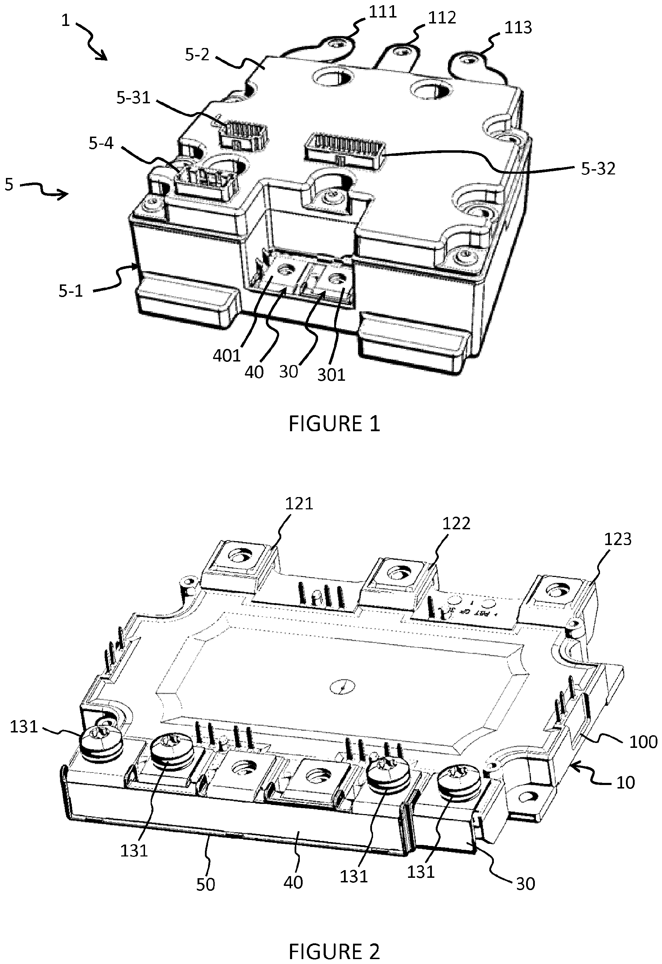

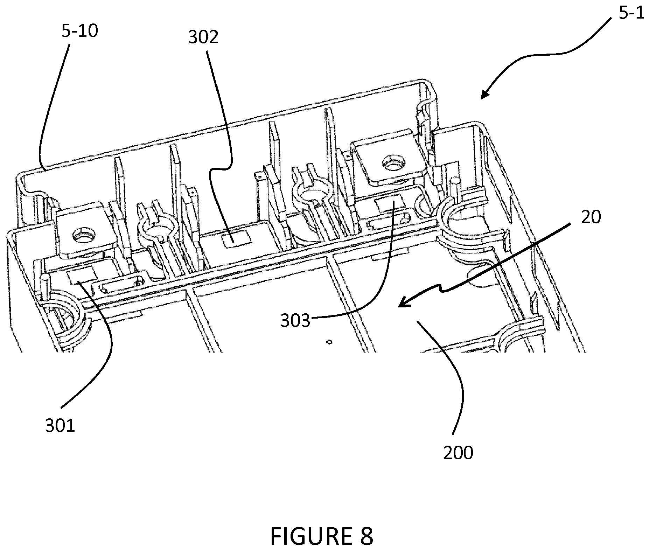

Dans l'exemple illustré à la figure 1, l'onduleur 1 comprend un boîtier 5 dans lequel sont montés, en référence à la figure 2, un module électronique de puissance 10, une unité électronique de contrôle (partiellement visible sur la figure 8) et une pluralité de conducteurs électriques 30, 40, 111, 112, 113. L'unité électronique de contrôle 20 comprend des composants pour contrôler les composants du module électronique de puissance 10. Plus précisément, l'unité électronique de contrôle 20 commande le module électronique de puissance 10 afin qu'il réalise la fonction de conversion du courant continu reçu de la batterie haute tension, définissant une tension continue entre le premier conducteur électrique 30 et le deuxième conducteur électrique 40, en trois courants de phase alternatifs de commande du moteur (ou vice-et-versa).

En référence aux figures 1 et 2, le module électronique de puissance 10 comprend un corps 100 sur lequel sont fixés les conducteurs électriques 30, 40, 111, 112, 113. Par ailleurs, le module électronique de puissance 10 comprend des composants électroniques de puissance par lesquels passe l'énergie alimentant la machine électrique, notamment destinés à transformer le courant continu en courants alternatifs ou vice-versa. Ces composants électroniques de puissance peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants électroniques de puissance sont des puces semi-conductrices nues pour lesquels le corps 100 réalise une encapsulation. En référence à la figure 2, le module électronique de puissance 10 comprend trois ports de phase 121, 122, 123 délivrant chacun un courant de phase de commande du moteur et d'autre part une borne électrique externe positive et une borne électrique externe négative (non représentées).

Dans l'exemple illustré aux figures 1 et 2, l'onduleur 1 comprend un premier conducteur électrique 30 destiné à relier électriquement l'onduleur 1 au potentiel positif de la batterie d'alimentation haute tension (non représentée), un deuxième conducteur électrique 40 destiné à relier électriquement l'onduleur 1 au potentiel négatif de la batterie d'alimentation haute tension et trois conducteurs dits « de phase » 111, 112, 113 destinés à relier électriquement l'onduleur 1 à la machine électrique.

En référence aux figures 1 et 2, chaque conducteur électrique 30, 40 se présente sous la forme d'une lame de laquelle s'étendent des éléments de fixation 301, 401 au corps 100 du module électronique de puissance 10 à l'aide d'une vis 131. Comme illustré à la figure 2, l'onduleur 1 comprend en outre une barre de fixation 50 électriquement isolante séparant le premier conducteur électrique 30 du deuxième conducteur électrique 40, notamment afin de prévenir les courts-circuits entre le premier conducteur électrique 30 et le deuxième conducteur électrique 40. A cette fin, la barre de fixation 50 est réalisée de préférence en un matériau plastique tel que, par exemple, du PBT GF30.

Chaque conducteur de phase 111, 112, 113 permet de connecter électriquement une phase de la machine électrique commandée par l'onduleur 1 avec le module électronique de puissance 10. On notera que, dans une autre forme de réalisation, l'onduleur 1 pourrait comprendre un nombre de conducteurs de phase 111, 112, 113 différent, notamment un nombre fonction du nombre de phases de la machine électrique commandée par l'onduleur 1.

Chaque connecteur de phase 111, 112, 113 est monté sur le port de phase 121, 122, 123 en y étant fixé, par exemple par l'intermédiaire d'une vis (non représentée), d'une soudure ou autre. Chaque conducteur de phase 111, 112, 113 traverse une ouverture du boîtier 5 pour permettre de relier l'onduleur 1 à la machine électrique et notamment permettre la circulation des courants alternatifs entre le module électronique de puissance 10 et la machine électrique.

En référence maintenant aux figures 1, 3 et 7, chaque conducteur de phase 111, 112, 113 se présente sous la forme d'une pièce monobloc, c'est-à-dire réalisées d'un seul tenant. Cette pièce se présente sous la forme d'une lame formée en la conformant dans un même matériau électriquement conducteur.

L'épaisseur des conducteurs de phase 111, 112, 113 peut être choisie en fonction de l'utilisation qui en est faite et notamment de l'intensité des courants qui la parcourt. Avantageusement, l'épaisseur des conducteurs de phase 111, 112, 113 est comprise entre 0,5 et 3 mm. De préférence, l'épaisseur du conducteur de phase 111, 112, 113 est de l'ordre de 1 mm, 1,5 mm ou 2 mm. Les conducteurs de phase 111, 112, 113 peuvent en outre avantageusement être recouverts d'un traitement de surface anti-usure, par exemple composée d'étain et/ou de nickel pour la compatibilité des matériaux ou améliorer le courant électrique.

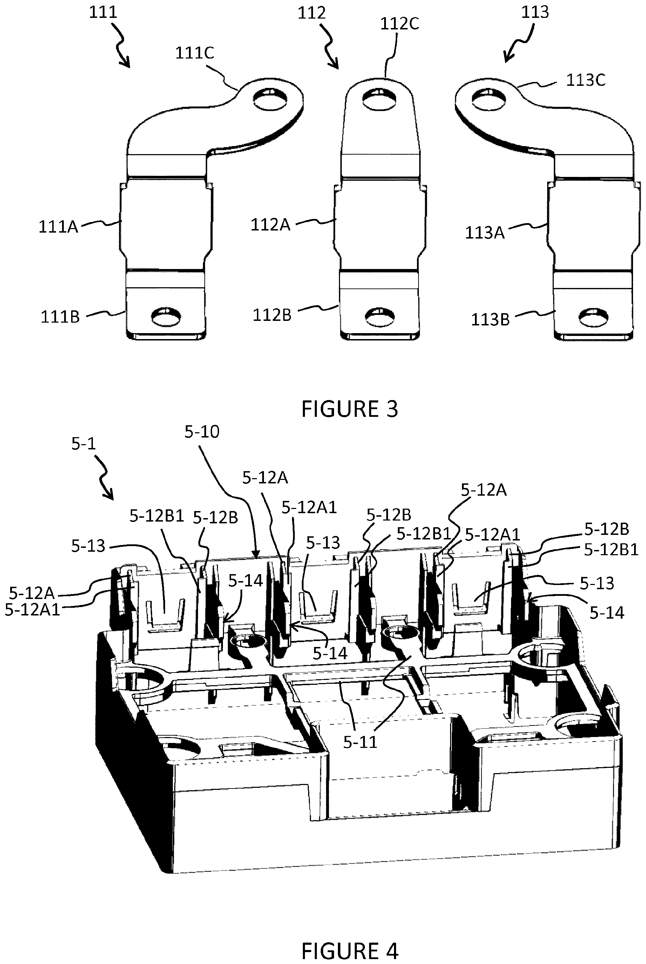

Dans l'exemple illustré sur la figure 3, chaque conducteur électrique 111, 112, 113 comprend une portion centrale 111A, 112A, 113A de laquelle s'étendent perpendiculairement mais dans une direction opposée une première extrémité de fixation 111B, 112B, 113B, et une deuxième extrémité de fixation 111C, 112C, 113C. La première extrémité de fixation 111B, 112B, 113B est destinée à être reliée à un port de phase 121, 122, 123 du module électronique de puissance 10, par exemple à l'aide d'une vis. A cette fin, la première extrémité de fixation 111B, 112B, 113B se présente sous la forme d'une portion plane adaptée pour venir en contact avec une portion plane d'un port de phase 121, 122, 123. La deuxième extrémité de fixation 111C, 112C, 113C est destinée à être reliée à un conducteur de phase (non représenté) de la machine électrique. A cette fin, la deuxième extrémité de fixation 111C, 112C, 113C se présente également sous la forme d'une portion plane adaptée pour venir en contact avec une portion plane d'un conducteur de phase de la machine électrique.

On notera que, dans cet exemple non limitatif, les deuxièmes extrémités 111C, 113C des conducteurs de phase 111 et 113 sont conformées de sorte à se rapprocher de la deuxième extrémité 112C du conducteur de phase 112 positionné au centre, qui se situe dans le prolongement de la portion centrale 112A dudit conducteur de phase 112 central. Ceci a pour effet de rapprocher les deuxièmes extrémités 111C, 112C, 113C des conducteurs de phase 111, 112, 113 afin de les connecter avec des conducteurs de phase correspondants, agencés similairement, de la machine électrique. Cependant, les deuxièmes extrémités 111C, 112C, 113C peuvent être formées différemment, notamment en fonction de l'environnement dans lequel l'onduleur 1 va être monté.

A cette fin, l'unité électronique de contrôle 20 se présente sous la forme d'une carte électronique 200, comme représenté sur la figure 8. La carte électronique 200 peut être montée sur une paroi du boîtier 5 ou un élément de support (non représenté, qui peut par exemple être une plaque) suspendu dans le logement défini par le boîtier 5. En particulier, le module électronique de puissance 10, l'élément de support et l'unité électronique de contrôle 20 peuvent être superposés l'un en vis-à-vis de l'autre dans le logement défini par le boîtier 5, l'élément de support se trouvant alors entre le module électronique de puissance 10 et l'unité électronique de contrôle 20. Par exemple, un tel élément de support peut être rapporté dans le boîtier 5 et maintenu en place en venant en appui contre des portions de matière dudit boîtier 5, notamment des excroissances issues de la surface du boîtier 5. Le support peut notamment être maintenu en place en venant en appui au niveau de sa périphérie. Cet élément de support peut par exemple être en métal pour améliorer la dissipation thermique de l'unité électronique de contrôle 20. L'unité électronique de contrôle 20 peut être configurée pour échanger, via les connecteurs de signaux 5-31, 5-32 représentés sur la figure 1 des signaux de données avec l'extérieur de l'onduleur 1, par exemple avec un contrôleur du véhicule.

En référence à la figure 8, les capteurs de courant 301, 302, 303, destinés à réaliser des mesures de l'intensité des courants circulant dans les conducteurs de phase 111, 112, 113, sont par exemple montés en surface de la carte électronique 200 de l'unité électronique de contrôle 20. Notamment, chaque capteur de courant 301, 302, 303 peut mesurer le courant à partir du champ magnétique généré par chaque conducteur de phase 111, 112, 113 en raison du passage du courant. Les capteurs de courants 301, 302, 303 sont par exemple des capteurs à effet Hall. Chaque capteur de courant 301, 302, 303 peut comprendre des broches qui sont reçues dans la carte électronique 200 de l'unité électronique de contrôle 20 pour y acheminer la valeur du courant mesuré.

Des pièces en matériau magnétique 5-14, en forme de 'U', représentés sur la figure 4, sont destinées à assurer une fonction de focalisation des champs magnétiques induits par les courants circulant dans chaque conducteur de phase 111, 112, 113 pour permettre auxdits capteurs 301, 302, 303, en particulier capteurs à effet Hall, de réaliser des mesures fiables de l'intensité desdits courants circulant dans les conducteurs de phase 111, 112, 113. Autrement dit, les pièces en 'U' 5-14 sont adaptées pour assurer le guidage du flux magnétique généré par le courant circulant dans chaque conducteur de phase 111, 112, 113, de façon focaliser ledit flux magnétique en direction d'un capteur, notamment d'un capteur à effet Hall 301, 302, 303, afin de permettre une mesure fiable de l'intensité du courant circulant dans ledit conducteur de phase 111, 112, 113.

Selon un mode de réalisation dans lequel les capteurs de courant 301, 302, 303 sont montés sur la carte électronique 200, ladite carte électronique 200 présente des fentes dans lesquelles les branches 5-142 de la pièce en forme de 'U' 5-14 sont engagées. Ainsi, les branches 5-142 de la pièce en forme de 'U' 5-14 viennent au plus près du capteur 301,302, 303 correspondant monté sur la carte électronique 200.

Notamment, la carte électronique 200 est perpendiculaire à la paroi 5-10 de l'élément de boîtier 5-1, et les branches 5-142 de la pièce en forme de 'U' 5-14 s'introduisent dans lesdites fentes suivant une direction parallèle au plan de ladite carte électronique 200.

Comme illustré sur la figure 1, le boîtier 5 comprend un élément de boîtier 5-1 et un couvercle 5-2, monté sur l'élément de boîtier 5. Le boîtier 5 comprend également un fond (non visible sur la figure 1) s'étendant sous l'élément de boîtier 5-1. Dans l'exemple illustré à la figure 1, l'onduleur 1 comprend en outre, de manière non limitative, deux connecteurs de signaux 5-31, 5-32, déjà décrits, et un connecteur d'alimentation 5-4 destiné à connecter l'onduleur 1 à un câble d'alimentation électrique, lesdits connecteurs étant montés sur le couvercle 5-2 du boîtier 5.

En référence désormais à la figure 4, l'élément de boîtier 5-1 se présente sous la forme d'une pièce monobloc réalisée par moulage d'un matériau plastique. L'élément de boîtier 5-1 comprend une paroi latérale 5-10 se présentant sous la forme d'une ceinture en forme de 'U' et des éléments de support 5-11 configurés pour recevoir le module électronique de puissance 10 et l'unité électronique de contrôle 20. Les éléments de support 5-11 comprennent par exemple des crochets permettant de fixer le corps 100 du module électronique de puissance 10.

L'élément de boîtier 5-1 comprend des organes de réception 5-12A, 5-12B, permettant de bloquer, par exemple par montage à force, les conducteurs de phase 111, 112, 113. Comme illustré sur la figure 4, ces organes de réception sont issus de matière de la paroi latérale 5-10 et comprennent trois paires de parois adaptée chacune pour recevoir un conducteur de phase 111, 112, 113.

Plus précisément, chaque paire de paroi comprend une première paroi 5-12A et une deuxième paroi 5-12B s'étendant parallèlement entre elles et perpendiculairement à la paroi latérale 5-10 de manière à bloquer un conducteur de phase 111, 112, 113. Dans cet exemple, la première paroi 5-12A et la deuxième paroi 5-12B de chaque paire de parois 5-12A, 5-12B s'étendent sensiblement sur toute la hauteur de la paroi latérale 5-10.

De préférence, chacune de la première paroi 5-12A et de la deuxième paroi 5-12B de chaque paire de parois 5-12A, 5-12B comprend au moins un godron. Un tel godron constitue une surépaisseur de matière qui sert à ajuster l'emboitement entre chaque paire de parois 5-12A, 5-12B et le conducteur de phase 111, 112, 113 correspondant de manière à les bloquer efficacement l'un dans l'autre. Dans cet exemple, les godrons sont issus de matière de la première paroi 5-12A et de la deuxième paroi 5-12B de chaque paire de parois 5-12A, 5-12B.

Toujours dans l'exemple illustré, la première paroi 5-12A comprend une portion de butée 5-12A1, s'étendant parallèlement à la paroi latérale 5-10 en direction de la deuxième paroi 5-12B, et la deuxième paroi 5-12B comprend une portion de butée 5-12B1, s'étendant parallèlement à la paroi latérale 5-10 en direction de la première paroi 5-12A.

Toujours en référence à la figure 4, l'élément de boîtier 5-1 comporte des paires fentes dans lesquelles sont engagées des pièces 5-14 ayant une section en forme de 'U'. Une paire de fentes est prévue de part et d'autre de chaque organe de réception 5-12A, 5-12B d'un conducteur de phase 111, 112, 113.

Les pièces 5-14, qui présentent une section en forme de 'U' assurent une fonction de focalisation de champ magnétique. Ces pièces en 'U' 5-14 sont fabriqués par moulage, séparément, de sorte à assurer une orientation des molécules dans la matière configurée pour permettre une fonction de focalisation de champ magnétique efficace vis-à-vis des champs magnétiques générées par les courants circulant dans les conducteurs de phase 111, 112, 113.

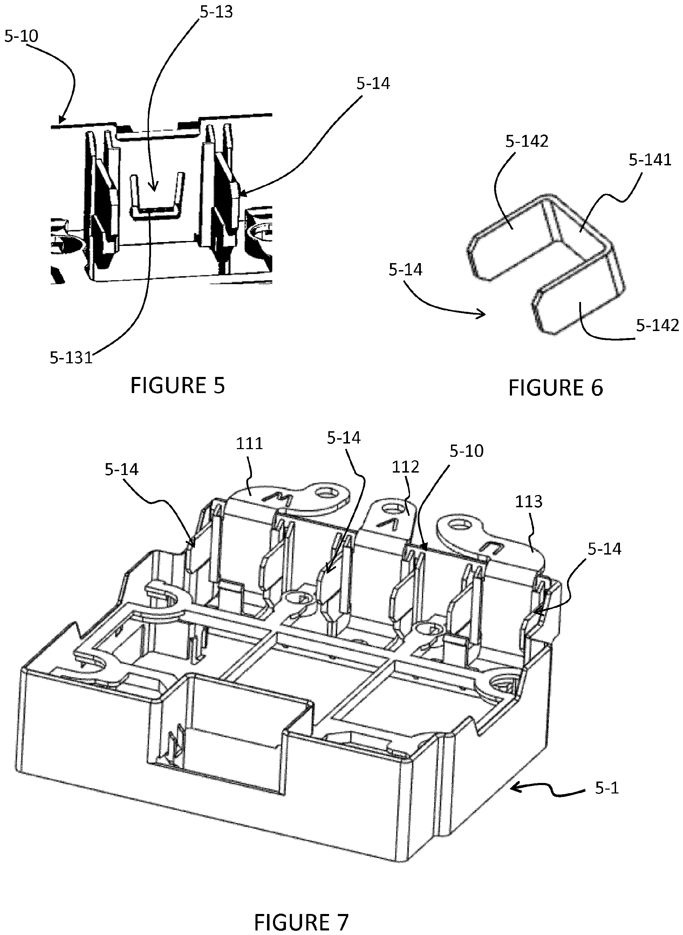

En référence à la figure 6, chaque pièce en 'U' 5-14 présente une base plane 5-141 et deux branches planes 5-142, parallèle entre elles et orthogonales à la base, destinées à être engagées dans les fentes d'une paire de fentes, de façon à ce que lesdites branches se trouvent de part et d'autre d'un organe de réception d'un conducteur de phase 111, 112, 113, la base plane de la pièce en 'U' venant en appui contre la paroi latérale 5-10, par l'extérieur de l'élément de boîtier.

En référence à la figure 5, entre deux fentes, une ouverture est aménagée dans la paroi latérale 5-10 pour former une languette souple 5-13 présentant une protubérance 5-131. La protubérance assure la fonction de clip de fixation destinée à coopérer avec la base plane du bouclier en 'U' de façon à retenir ladite pièce en 'U' contre l'élément de boîtier.

D'un autre côté, les conducteurs de phase 111, 112, 113, une fois insérés dans l'élément de boîtier 5 et reçus par leur organe de réception respectif 5-12A, 5-12B, viennent en appui, via leur portion centrale 111A, 112A, 113A, contre la paroi latérale 5-10 et donc contre la languette souple 5-13, verrouillant de ce fait pièce en 'U' en inhibant toute mobilité de ladite languette souple 5-13 dans une direction opposée à la base du 'U', empêchant le dégagement de ladite pièce en 'U' 5-14.

Lors de l'assemblage de l'onduleur, le module électronique de puissance 10 et l'unité électronique de contrôle 20 sont d'abord assemblés.

Les pièces en 'U' 5-14 sont ensuite engagées dans l'élément de boîtier 5-1 par insertion des branches planes 5-142 dans les fentes prévues à cet effet.

La languette souple 5-13 présente une protubérance assurant une fixation par clipage de chaque pièce en en 'U' 5-14.

Chaque conducteur de phase 111, 112, 113 est ensuite inséré, par exemple monté à force, par glissement entre chaque paire de parois 5-12A, 5-12B. Les conducteurs de phase 111, 112, 113 sont par exemple bloqués par des godrons entre la première paroi 5-12A et la deuxième paroi 5-12B.

La figure 7 montre un élément de boîtier 5-1 dans lequel trois pièces en 'U' 5-14 et trois conducteurs de phase 111, 112, 113 ont été insérés.

Ensuite, chaque conducteur de phase 111, 112, 113 est vissé sur le port de phase 121, 122, 123 correspondant de manière à le relier électriquement aux ports de phase 121, 122, 123 du module électronique de puissance 10.

Les portions de butée de chaque paire de parois 5-12A, 5-12B permettent en outre de maintenir les conducteurs de phase 111, 112, 113 entre la première paroi 5-12A et la deuxième paroi 5-12B de chaque paire de parois 5-12A, 5-12B.

Par leur portion centrale 111A, 112A, 113A qui vient en appui contre la languette souple 5-13, chaque conducteur de phase 111, 112, 113 réalise une butée inhibant tout déplacement de la languette souple 5-13 dans une direction opposée à la portion de base plane 141 de chaque pièce en 'U' 5-14. De ce fait, les pièces en 'U' 5-14 sont verrouillées en position et ne peuvent plus être désengagées tant que le conducteur de phase 111, 112, 113 correspondant est présent en vis-à-vis de la languette souple 5-13.

Le couvercle 5-2 et le fond du boîtier 5 peuvent ensuite être fixés sur l'élément de boîtier 5-1 de manière à fermer le boîtier et, par exemple, rendre l'onduleur 1 étanche. Les conducteurs de phase 111, 112, 113 de l'onduleur 1 peuvent ensuite être connectés électriquement à la machine électrique de même que les conducteurs électriques de potentiel positif et négatif 30, 40 peuvent être connectés électriquement à la batterie haute tension du véhicule.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuvent-être indépendantes entre elles d'un mode à l'autre, ou combinées entre elles, comme cela ressort des revendications.

## Revendications

1. Elément de boîtier (5-1) d'un premier équipement électrique (1), ledit élément de boîtier (5-1) étant configuré pour recevoir au moins un conducteur électrique (111, 112, 113) destiné à recevoir un courant électrique,
ledit élément de boîtier (5-1) étant **caractérisé en ce qu'**il comprend une paire de fentes aménagées dans une paroi (5-10) de l'élément de boîtier, la paire de fentes comprenant une fente de part et d'autre d'une zone de réception (5-12A, 5-12B) destinée à recevoir ledit conducteur électrique et ladite paire de fentes étant destinée à permettre l'engagement d'une pièce (5-14) ayant une section en forme de 'U' présentant une base (5-141) et deux branches (5-142) parallèles entre elles et orthogonales à la base (5-141), lesdites branches (5-142) étant configurées pour être engagées dans lesdites fentes de part et d'autre de ladite zone de réception (5-12A, 5-12B), de sorte que la pièce en forme de 'U' (5-14) assure un guidage d'un flux magnétique généré par un courant électrique circulant dans ledit conducteur électrique (111, 112, 113).

2. Elément de boîtier (5-1) selon la revendication 1, comprenant une ouverture en 'U' aménagée dans la paroi (5-10) entre les fentes de la paire de fentes de façon à former une languette (5-13), ladite languette (5-13) présentant une protubérance (5-131) et une souplesse adaptée pour assurer une fonction de clip de fixation pour retenir la base (5-141) de la pièce en forme de 'U' (5-14) engagée dans la paire de fentes.

3. Équipement électrique comprenant un élément de boîtier selon la revendication 1 ou 2, comprenant au moins une pièce en matériau magnétique en forme de 'U' (5-14), présentant une base (5-141) et deux branches (5-142) parallèles entre elles et orthogonales à la base (5-141), lesdites branches (5-142) étant engagées dans lesdites fentes de part et d'autre de la zone de réception (5-12A, 5-12B), ladite pièce en forme de 'U' étant configurée pour assurer un guidage d'un flux magnétique généré par un courant circulant dans un conducteur électrique (111, 112, 113) reçu dans la zone de réception (5-12A, 5-12B).

4. Équipement électrique selon la revendication 3, comprenant un conducteur électrique (111, 112, 113) monté dans la zone de réception (5-12A, 5-12B), et dans lequel le conducteur électrique (111, 112, 113) verrouille la pièce en forme de 'U' (5-14).

5. Équipement électrique selon la revendication précédente, comprenant un élément de boîtier (5-1) selon la revendication 2, dans lequel la souplesse de la languette (5-13) est configurée pour permettre un désengagement de la pièce en forme de 'U' (5-14) par une pression sur ladite languette (5-13) dans une direction opposée à la base (5-141) de la pièce en forme de 'U' (5-14).

6. Équipement électrique selon les revendications 4 et 5, dans lequel le conducteur électrique (111, 112, 113) verrouille la pièce en forme de 'U' (5-14) en inhibant un déplacement de la languette (5-13) dans une direction opposée à la base (5-141) de la pièce en forme de 'U' (5-14) susceptible de permettre un désengagement de ladite pièce en forme de 'U' (5-14).

7. Équipement électrique selon la revendication précédente, dans lequel une portion (111 A, 112A, 113A) du conducteur électrique (111, 112, 113) assure la fonction de verrouillage de la pièce en forme de 'U' (5-14), ladite portion (111A, 112A, 113A) correspondant à une surface dudit conducteur électrique (111, 112, 113) parallèle à la paroi (5-10) et venant en appui contre la languette (5-13), inhibant tout degré de liberté de la languette (5-13) dans une direction orthogonale à ladite paroi (5-10) et opposée à la base (5-141) de ladite pièce en forme de 'U' (5-14).

8. Equipement électrique (1) selon l'une des revendications 4 à 7, dans lequel la paroi (5-10) forme une paroi externe de l'équipement électrique (1) et le conducteur électrique (111, 112, 113) comprend une extrémité formant une borne électrique externe de l'équipement électrique (1) et une autre connectée à un composant électrique inclus dans ledit élément de boîtier (5-1), ladite pièce en 'U' (5-14) étant configurée pour guider un champ magnétique produit par un courant circulant dans ledit conducteur électrique (111, 112, 113) pour une mesure dudit courant.

9. Equipement électrique (1) selon l'une des revendications 3 à 8, comprenant un capteur (301, 302, 303), notamment un capteur à effet Hall, situé entre les branches (5-142) de la pièce en forme de 'U' (5-14) de manière à mesurer un courant circulant dans le conducteur électrique (111, 112, 113) à partir d'un champ magnétique guidé par la pièce en forme de 'U' (5-14).

10. Equipement électrique (1) selon la revendication précédente, comprenant une carte électronique (200) montée dans ledit élément de boîtier (5-1), ledit capteur (301, 302, 303) étant monté sur la carte électronique (200), et ladite carte électronique (200) présentant des fentes dans lesquelles les branches (5-142) de la pièce en forme de 'U' (5-14) sont engagées.

11. Equipement électrique (1) selon la revendication précédente, dans lequel la carte électronique (200) est perpendiculaire à la paroi (5-10), et les branches (5-142) de la pièce en forme de 'U' (5-14) s'introduisent dans lesdites fentes suivant une direction parallèle au plan de ladite carte électronique (200).

## Patentansprüche

1. Gehäuseelement (5-1) einer ersten elektrischen Ausstattung (1), wobei das Gehäuseelement (5-1) ausgelegt ist, um mindestens einen elektrischen Leiter (111, 112, 113) aufzunehmen, der bestimmt ist, einen elektrischen Strom aufzunehmen,
wobei das Gehäuseelement (5-1) **dadurch gekennzeichnet ist, dass** es ein Paar Schlitze umfasst, die in einer Wand (5-10) des Gehäuseelements eingerichtet sind, wobei das Paar Schlitze einen Schlitz beiderseits einer Aufnahmezone (5-12A, 5-12B) umfasst, die bestimmt ist, den elektrischen Leiter aufzunehmen und das Paar Schlitze bestimmt ist, das Einsetzen eines Teils (5-14) mit einem Querschnitt in U-Form zu erlauben, das eine Basis (5-141) und zwei zueinander parallele und zu der Basis (5-141) orthogonale Schenkel (5-142) aufweist, wobei die Schenkel (5-142) ausgelegt sind, um in die Schlitze beiderseits der Aufnahmezone (5-12A, 5-12B) eingesetzt zu sein, so dass das Teil in U-Form (5-14) eine Führung eines von einem elektrischen Strom, der in dem elektrischen Leiter (111, 112, 113) fließt, erzeugten Magnetstroms sicherstellt.

2. Gehäuseelement (5-1) nach Anspruch 1, umfassend eine U-förmige Öffnung, die in der Wand (5-10) zwischen den Schlitzen des Schlitzpaares eingerichtet ist, so dass eine Zunge (5-13) gebildet wird, wobei die Zunge (5-13) einen Vorsprung (5-131) aufweist und eine Elastizität, die geeignet ist, eine Befestigungsclipfunktion zu sicherzustellen, um die Basis (5-141) des Teils in U-Form (5-14) in dem Schlitzpaar eingesetzt zu halten.

3. Elektrische Ausstattung, umfassend ein Gehäuseelement nach Anspruch 1 oder 2, umfassend mindestens ein Teil aus magnetischem Material in U-Form (5-14), aufweisend eine Basis (5-141) und zwei zueinander parallele und zu der Basis (5-141) orthogonale Schenkel (5-142), wobei die Schenkel (5-142) in die Schlitze beiderseits der Aufnahmezone (5-12A, 5-12B) eingesetzt sind, wobei das Teil in U-Form (5-14) ausgelegt ist, um eine Führung eines von einem elektrischen Strom, der in einem elektrischen Leiter (111, 112, 113) fließt, der in der Aufnahmezone (5-12A, 5-12B) aufgenommen ist, erzeugten Magnetstrom sicherzustellen.

4. Elektrische Ausstattung nach Anspruch 3, umfassend einen elektrischen Leiter (111, 112, 113), der in der Aufnahmezone (5-12A, 5-12B) angebracht ist, und wobei der elektrische Leiter (111, 112, 113) das Teil in U-Form (5-14) verriegelt.

5. Elektrische Ausstattung nach vorangehendem Anspruch, umfassend ein Gehäuseelement (5-1) nach Anspruch 2, wobei die Elastizität der Zunge (5-13) ausgelegt ist, um ein Lösen des Teils in U-Form (5-14) durch einen Druck auf die Zunge (5-13) in eine Richtung entgegengesetzt zur Basis (5-141) des Teils in U-Form (5-14) zu erlauben.

6. Elektrische Ausstattung nach den Ansprüchen 4 und 5, wobei der elektrische Leiter (111, 112, 113) das Teil in U-Form (5-14) durch Hemmen einer Verlagerung der Zunge (5-13) in eine Richtung entgegengesetzt zur Basis (5-141) des Teils in U-Form (5-14), die imstande ist, ein Lösen des Teils in U-Form (5-14) zu erlauben, verriegelt.

7. Elektrische Ausstattung nach vorangehendem Anspruch, wobei ein Abschnitt (111A, 112A, 113A) des elektrischen Leiters (111, 112, 113) die Verriegelungsfunktion des Teils in U-Form (5-14) sicherstellt, wobei der Abschnitt (111A, 112A, 113A) einer Fläche des elektrischen Leiters (111, 112, 113) entspricht, der parallel zu der Wand (5-10) ist und sich auf der Zunge (5-13) abstützt, wobei jeder Freiheitsgrad der Zunge (5-13) in einer Richtung, die zu der Wand (5-10) orthogonal und zu der Basis (5-141) des Teils in U-Form (5-14) entgegengesetzt ist, gehemmt wird.

8. Elektrische Ausstattung (1) nach einem der Ansprüche 4 bis 7, wobei die Wand (5-10) eine Außenwand der elektrischen Ausstattung (1) bildet und der elektrische Leiter (111, 112, 113) ein Ende umfasst, das eine äußere elektrische Klemme der elektrischen Ausstattung (1) bildet und ein anderes, das mit einem elektrischen Bauteil verbunden ist, das in dem Gehäuseelement (5-1) enthalten ist, wobei das U-förmige Teil (5-14) ausgelegt ist, um ein von einem Strom, der in dem elektrischen Leiter (111, 112, 113) fließt, erzeugtes Magnetfeld für eine Messung des Stroms zu führen.

9. Elektrische Ausstattung (1) nach einem der Ansprüche 3 bis 8, umfassend einen Sensor (301, 302, 303), insbesondere einen Sensor mit Hall-Effekt, der sich zwischen den Schenkeln (5-142) des Teils in U-Form (5-14) derart befindet, dass auf der Basis eines Magnetfelds, das von dem Teil in U-Form (5-14) geführt wird, ein Strom gemessen wird, der in dem elektrischen Leiter (111, 112, 113) fließt.

10. Elektrische Ausstattung (1) nach vorangehendem Anspruch, umfassend eine elektronische Karte (200), die in dem Gehäuseelement (5-1) angebracht ist, wobei der Sensor (301, 302, 303) auf der elektronischen Karte (200) angebracht ist und die elektronische Karte (200) Schlitze aufweist, in die die Schenkel (5-142) des Teils in U-Form (5-14) eingesetzt sind.

11. Elektrische Ausstattung (1) nach vorangehendem Anspruch, wobei die elektronische Karte (200) senkrecht zur Wand (5-10) ist und sich die Schenkel (5-142) des Teils in U-Form (5-14) in die Schlitze gemäß einer Richtung parallel zur Ebene der elektronischen Karte (200) einfügen.

## Claims

1. Casing element (5-1) of a first electric equipment (1), said casing element (5-1) being configured to house at least one electrical conductor (111, 112, 113) configured to receive an electric current,
said casing element (5-1) being **characterised in that** it comprises a pair of slots provided in a wall (5-10) of the casing element, the pair of slots comprising a slot on either side of a reception area (5-12A, 5-12B) configured to house said electrical conductor, and said pair of slots being provided to allow the insertion of a part (5-14) with a U-shaped section comprising a base (5-141) and two arms (5-142) parallel to one another and orthogonal to the base (5-141), said arms (5-142) being configured to be inserted in said slots on either side of said reception area (5-12A, 5-12B), so that the U-shaped part (5-14) is able to guide a magnetic flux generated by an electric current circulating in said electrical conductor (111, 112, 113).

2. Casing element (5-1) according to claim 1, comprising a U-shaped opening provided in the wall (5-10) between the slots of the pair of slots so as to form a tab (5-13), said tab (5-13) comprising a protrusion (5-131) and a degree of flexibility adapted to ensure a fixation clip function to hold the base (5-141) of the U-shaped part (5-14) inserted in the pair of slots.

3. Electric equipment comprising a casing element according to claim 1 or 2, comprising at least one U-shaped part (5-14) made of a magnetic material, with a base (5-141) and two arms (5-142) parallel to one another and orthogonal to the base (5-141), said arms (5-142) being inserted in said slots on either side of the reception area (5-12A, 5-12B), said U-shaped part being configured to guide a magnetic flux generated by a current circulating in the electrical conductor (111, 112, 113) housed in the reception area (5-12A, 5-12B).

4. Electric equipment according to claim 3 comprising an electrical conductor (111, 112, 113) mounted in the reception area (5-12A, 5-12B), and wherein the electrical conductor (111, 112, 113) locks the U-shaped part (5-14).

5. Electric equipment according to the preceding claim, comprising a casing element (5-1) according to claim 2, wherein the flexibility of the tab (5-13) is configured to allow the release of the U-shaped part (5-14) by pressure applied on said tab (5-13) in an direction opposite to the base (5-141) of the U-shaped part (5-14).

6. Electric equipment according to claims 4 and 5, wherein the electrical conductor (111, 112, 113) locks the U-shaped part (5-14) by preventing the movement of the tab (5-13) in an direction opposite to the base (5-141) of the U-shaped part (5-14) that is likely to cause the release of said U-shaped part (5-14).

7. Electric equipment according to the preceding claim, wherein a portion (111A, 112A, 113A) of the electrical conductor (111, 112, 113) provides the locking function of the U-shaped part (5-14), said portion (111A, 112A, 113A) corresponding to a surface of said electrical conductor (111, 112, 113) parallel to the wall (5-10) and coming to bear against the tab (5-13), preventing all movement of the tab (5-13) in a direction orthogonal to said wall (5-10)and opposite to the base (5-141) of said U-shaped part (5-14).

8. Electric equipment (1) according to one of the claims 4 to 7, wherein the wall (5-10) forms an outer wall of the electric equipment (1) and the electrical conductor (111, 112, 113) comprises an end that forms an external electric terminal of the electric equipment (1) and another end connected to an electric component included in said casing element (5-1), said U-shaped part (5-14) being configured to guide a magnetic field produced by a current circulating in said electric conductor (111, 112, 113) to perform a measurement of said current.

9. Electric equipment (1) according to one of the claims 3 to 8, comprising a sensor (301, 302, 303), in particular a Hall effect sensor, located between the arms (5-142) of the U-shaped part (5-14) so as to measure a current circulating in the electrical conductor (111, 112,113) from a magnetic field guided by the U-shaped part (5-14).

10. Electric equipment (1) according to the preceding claim, comprising a printed circuit board (200) mounted in said casing element (5-1), said sensor (301, 302, 303) being mounted on the printed circuit board (200), and said printed circuit board (200) comprising slots in which the arms (5-142) of the U-shaped part (5-14) are inserted.

11. Electric equipment (1) according to the preceding claim, wherein the printed circuit board (200) is perpendicular to the wall (5-10), and the arms (5-142) of the U-shaped part (5-14) are introduced into the slots following a direction that is parallel to the plane of said printed circuit board (200).
